# EUROPEAN PATENT SPECIFICATION

(11) **EP 4 295 396 B1**
(45) Date of publication and mention of the grant of the patent: **27.05.2026**
(21) Application number: 22706986.1
(22) Date of filing: 16.02.2022
(51) Int. Cl.: H01L 23/473

(54) **IC PACKAGE WITH EMBEDDED LIQUID-BASED COOLING SYSTEM**
IC-GEHÄUSE MIT EINGEBETTETEM FLÜSSIGKEITSBASIERTEM KÜHLSYSTEM
GROUPE DE CI À SYSTÈME DE REFROIDISSEMENT INCORPORÉ À BASE DE LIQUIDE

(30) Priority: 17.02.2021 US 202117177941
(43) Date of publication of application: 27.12.2023
(73) Proprietor: Meta Platforms, Inc., Menlo Park, CA 94025 (US)
(72) Inventor: MORTENSON, David Sebastien, Menlo Park, California 94025 (US); VIJAYRAO, Narsing Krishna, Menlo Park, California 94025 (US)
(74) Representative: Murgitroyd & Company
(86) International application number: PCT/US2022/016557
(87) International publication number: WO 2022/177957

(56) References cited:
- WO-A2-2010/117874
- CN-A- 111 081 665
- US-A1- 2016 037 682
- US-B1- 7 763 973

## Description

### TECHNICAL FIELD

This disclosure generally relates to systems and methods of integrated circuits (ICs) having cooling systems embedded within. In particular, it relates to an IC package with an embedded liquid-based cooling system for cooling the IC package.

### BACKGROUND

As integrated circuit (ICs) designers and fabricators continue to increase the functionality and speed available within a single IC package, the amount of power consumed, and thus the amount of heat dissipated, by the IC continues to increase similarly. Consequently, those ICs that tend to consume the most power, including, but not limited to, central processing units (CPUs), graphics processing units (GPUs), and the like, are traditionally the focus of most IC-specific passive heat mitigation efforts.

Depending on the size of the IC package, the circuit design of the IC, the speed at which the IC is to be operated, and other factors, the maximum amount of heat to be dissipated under a maximum expected workload (often referred to as the "thermal design power" (TDP) of the IC) may indicate whether an IC-specific heat mitigation strategy is required. In some examples, a TDP of at least 150 watts (W) may indicate the need for a passive heat sink. Typically, a heat sink (e.g., fashioned from an aluminum alloy, copper, or other metal) is coupled to a top flat surface of the IC package using a thermal adhesive to maximize heat transfer from the top of the IC package to the heat sink. Further, the heat sink may incorporate a number of fins or similar physical features to increase an amount of surface area of the heat sink. Air flow across the fins of the heat sink may then serve to remove thermal energy from the heat sink to increase the cooling effect of the heat sink on the corresponding IC package. In some examples, this air flow may be provided by way of a separate fan installed in an enclosure that surrounds the IC package and other circuitry, or via an IC-specific fan coupled more directly to the heat sink.

IC packages with higher TDPs, such as those exceeding 400 W, may benefit from the use of a liquid cooling system coupled to a top of the IC package. Such a system may include tubing that carries a liquid (e.g., distilled water) by way of a pump to a metallic device (e.g., a water block) that is coupled to the top of the IC package, as well as a radiator. In operation, the liquid is pumped through the water block (e.g., to extract heat from the IC package) and through the radiator (e.g., to extract the heat from the liquid, possibly assisted by an external fan).

The ability of heat sinks, water blocks, and other devices that may be attached to a top external surface of an IC package to extract a sufficient amount of heat therefrom continues to be challenged, as ICs with increasing TDPs (e.g., 1 kW or more) continue to be proposed and designed.

The following patent documents provide background useful for understanding the invention: WO/2010/117874 discloses an apparatus and method for optimizing performance of multi-circuit heat exchangers; US 2016/003/7682 discloses methods for local temperature control of integrated circuits and locally temperature controlled electro-rheological micro-channel anisotropic cooled integrated circuits; CN 111081665 relates to the technical field of heat dissipation of electronic components and discloses a device for the heat dissipation of a multi-heat-source device; and US7763973 (B1) discloses an integrated heat sink for a microchip includes a substrate having a plurality of interconnected electronic devices formed in a plurality of layers. At least one heat sink element is interposed within the layers and includes a microchannel to provide a fluid flow path for heat transfer. Other embodiments include a method of making an integrated heat sink for a microchip.

### SUMMARY

The present disclosure is generally directed to an IC package with a plurality of microchannels (e.g., channels of a few millimeters in diameter) defined within, with a plurality of flow valves located within the microchannels. Further included within the IC package may be a plurality of sensors (e.g., heat sensors) distributed therein. Control logic, which may be incorporated within the IC package or located external thereto, may individually control the operation of each of the plurality of flow valves based on the signals received from the plurality of sensors to control flow of liquid (e.g., water) through the microchannels to maintain a desired temperature level for the IC. As will be explained in greater detail below, embodiments of the present disclosure may facilitate greater heat extraction than more conventional technologies, thus supporting the use of high-TDP ICs.

Features from any of the embodiments described herein may be used in combination with one another in accordance with the general principles described herein. These and other embodiments, features, and advantages will be more fully understood upon reading the following detailed description in conjunction with the accompanying drawings and claims.

In an aspect of the invention there is provided an integrated circuit (IC) package comprising: an IC die carrying electronic circuitry; an encapsulation material at least partially covering the IC die, wherein: the encapsulation material defines a plurality of microchannels within the encapsulation material; and the plurality of microchannels are configured to carry fluid through the encapsulation material between one or more microchannel inlets and one or more microchannel outlets located at an exterior of the encapsulation material; a plurality of flow valves positioned in the plurality of microchannels; and a plurality of sensors, wherein each sensor of the plurality of sensors produces a signal indicating a temperature at a location of the sensor.

At least some of the plurality of microchannels are coupled together to form an interconnected microchannel network.

A first subset of the plurality of microchannels may be directed along a first direction parallel to the IC die; and a second subset of the plurality of microchannels may be directed along a second direction parallel to the IC die and may be orthogonal to the first direction.

Each of the first subset of the plurality of microchannels may intersect with the second subset of the plurality of microchannels to form an interconnected microchannel grid which may comprise a plurality of microchannel segments; and each microchannel segment of the plurality of microchannel segments may couple two intersections of the first subset and the second subset.

The first subset of the plurality of microchannels may be coupled at opposing ends to separate ones of the one or more microchannel inlets and separate ones of the one or more microchannel outlets.

Each microchannel segment of at least some of the plurality of microchannel segments may incorporate a flow valve of the plurality of flow valves.

The plurality of sensors may be arranged in a two-dimensional array parallel to a top surface of the IC die.

Each of the plurality of sensors may be aligned vertically relative to each intersection of the first subset and the second subset.

Each of the plurality of sensors may be aligned vertically relative to each microchannel segment of the plurality of microchannel segments.

At least one of the plurality of flow valves may be configured to operate either in a fully open state or in a fully closed state.

At least one of the plurality of flow valves may be configured to operate in at least one partially open state.

In an aspect of the invention there is provided a cooling system for an IC package, the cooling system comprising: a plurality of microchannels defined within an encapsulation material of the IC package, wherein: the encapsulation material at least partially covers an IC die carrying electronic circuitry; and the plurality of microchannels are configured to carry fluid through the encapsulation material between one or more microchannel inlets and one or more microchannel outlets located at an exterior of the encapsulation material; a plurality of flow valves positioned in the plurality of microchannels; a pump that pumps fluid through the plurality of microchannels from the one or more microchannel inlets to the one or more microchannel outlets; a plurality of sensors located in the IC package, and valve control logic that: receives, from each sensor of the plurality of sensors, a signal indicating a temperature at a location of the sensor; and controls, in response to the signals, each flow valve of the plurality of flow valves.

The valve control logic may control the plurality of flow valves to increase fluid flow to at least one area of increased temperature, as may be indicated by the signals from the plurality of sensors.

The valve control logic may control the plurality of flow valves to decrease fluid flow to at least one area of decreased temperature, as may be indicated by the signals from the plurality of sensors.

The valve control logic may control the plurality of flow valves to create a plurality of separate fluid flows through the plurality of microchannels between the one or more microchannel outlets.

The one or more microchannel inlets may comprise a plurality of microchannel inlets; the one or more microchannel outlets may comprise a plurality of microchannel outlets; and the valve control logic may control the plurality of flow valves to create a plurality of separate fluid flows through the plurality of microchannels, the plurality of microchannel inlets, and the plurality of microchannel outlets.

In an aspect of the invention there is provided a method of cooling an IC package, the method comprising: receiving, from each sensor of a plurality of sensors included in the IC package that includes an IC die carrying electronic circuitry, a signal indicating a temperature at a location of the sensor; and controlling each flow valve of a plurality of flow valves located in a plurality of microchannels defined in an encapsulation material at least partially covering the IC die in response to the signals received from the plurality of sensors, wherein the plurality of microchannels are configured to carry fluid through the encapsulation material between one or more microchannel inlets and one or more microchannels outlets located at an exterior of the encapsulation material.

Controlling each flow valve of the plurality of the flow valves may comprise: identifying a plurality of areas of the IC package exhibiting increased heat based on the signals; and controlling each flow valve of the plurality of flow valves to increase fluid flow in the plurality of microchannels through the plurality of areas.

Controlling each flow valve of the plurality of flow valves may further comprise controlling each flow valve of the plurality of flow valves to decrease fluid flow in the plurality of microchannels through at least one area of the IC package outside the plurality of areas.

Controlling each flow valve of the plurality of flow valves may further comprise controlling each flow valves of the plurality of flow valves to create separate fluid flows between the one or more microchannel inlets and the one or more microchannel outlets for each of the plurality of areas.

### BRIEF DESCRIPTION OF THE DRAWINGS

The accompanying drawings illustrate a number of exemplary embodiments and are a part of the specification. Together with the following description, these drawings demonstrate and explain various principles of the present disclosure.
FIG. 1 is a side cross-section of an exemplary integrated circuit (IC) package configured to implement a liquid-based cooling system for the IC package.
FIG. 2 is a top cross-section of the exemplary IC package of FIG. 1 depicting fluid microchannels and associated flow valves.
FIG. 3 is a second top cross-section of the exemplary IC package of FIGS. 1 and 2 depicting a plurality of sensors in the IC package.
FIG. 4 is a block diagram of an exemplary cooling system including the exemplary IC package of FIGS. 1-3.
FIG. 5 is a flow diagram of an exemplary method of operating the exemplary cooling system of FIG. 4.

Throughout the drawings, identical reference characters and descriptions indicate similar, but not necessarily identical, elements. While the exemplary embodiments described herein are susceptible to various modifications and alternative forms, specific embodiments have been shown by way of example in the drawings and will be described in detail herein.

### DETAILED DESCRIPTION

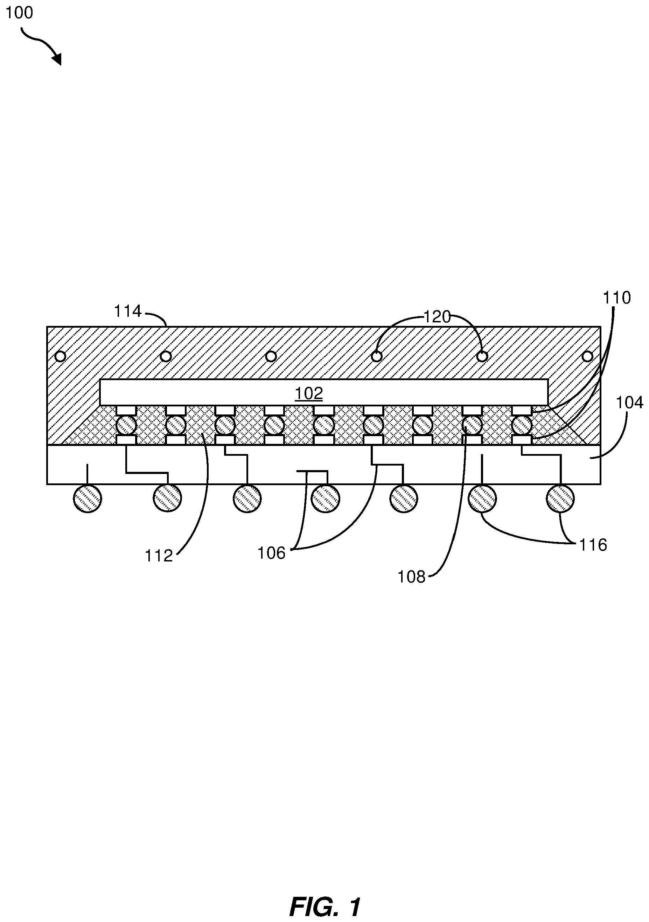

FIG. 1 is a side cross-section of an exemplary IC package 100 that is configured to implement an embedded liquid-based cooling system. In the description of IC package 100, various directional references (e.g., top, bottom, up, down, and so on) are provided relative to the horizontal orientation of IC package 1007 as illustrated in FIG. 1. However, such directional references are provided only for explanatory purposes, and other orientations of IC package 100, when deployed in an electronic system, are also possible.

As depicted in FIG. 1, IC package 100 may include an IC die 102 that carries electronic circuitry, the operation of which may generate heat. To enable electrical connection to various portions of the circuitry carried by IC die 102, a plurality of conductive pads 110 coupled to various points of the circuitry may be distributed (e.g., in a two-dimensional grid) along one or more surfaces (e.g., along the bottom) of IC die 102. Further, in some embodiments, corresponding conductive pads 110 may be provided along a surface (e.g., along the top) of a substrate 104 to be positioned under IC die 102. Substrate 104 may be a multilayer organic substrate, although substrate 104 may include other types of materials and/or structures in other examples. Substrate 104 may include a plurality of traces 106 that conductively couple conductive pads 110 along the top of substrate 104 to a plurality of solder bumps 116 along an opposing surface (e.g., along the bottom) of substrate 104. In some examples, solder bumps 116 may be spaced to facilitate electrical connection with corresponding pads of a printed circuit board (PCB) (not shown in FIG. 1), such by heat or another soldering process. Also, in some embodiments, conductive pads 110 of IC die 102 may be electrically connected to corresponding conductive pads 110 of substrate 104 by way of conductive bumps 108 (e.g., solder bumps). In addition, in some embodiments, after coupling IC die 102 to substrate 104, as described above, an underfiller 112 made of a nonconductive substance may be applied (e.g., heated and flowed) between IC die 102 and substrate 104 such that, when underfiller 112 cools, the combination of IC die 102, substrate 104, and underfiller 112 forms a mechanically stable structure in the presence of physical shock, extreme heat, and/or other challenging physical events.

While FIG. 1 depicts a particular structure that includes IC die 102 and an interconnection structure for facilitating electrical connection between IC die 102 and a PCB or other electronic structure, other structures involving IC die 102 may be employed in IC package 100 in other embodiments.

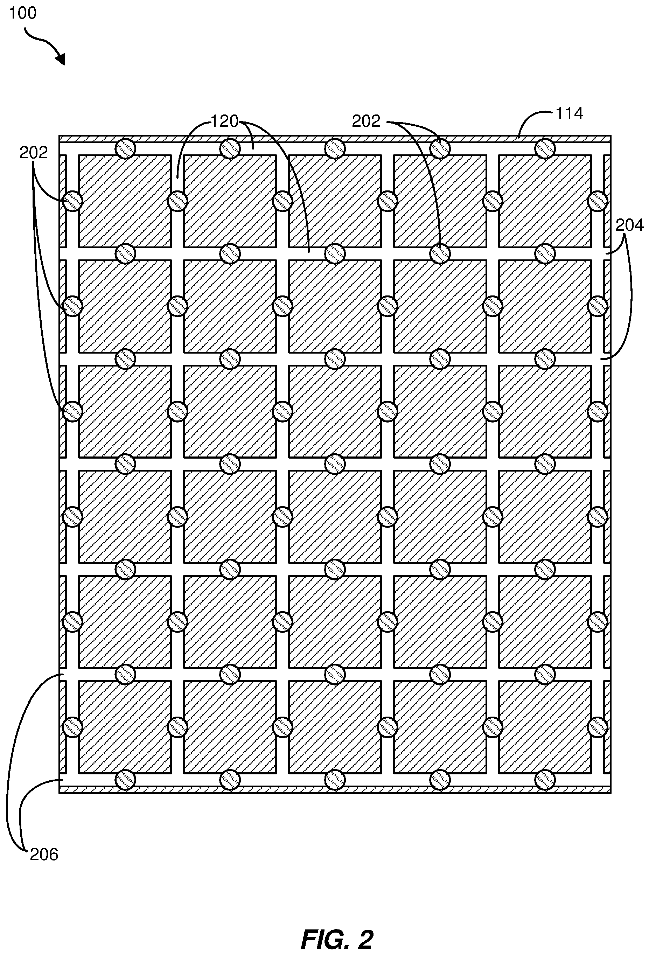

To facilitate protection of IC die 102 from a variety of environmental conditions, an encapsulation material 114 (e.g., an epoxy that is molded over IC die 102) may be applied over IC die 102, as well as possibly substrate 104 and underfiller 112. Conventionally, passive cooling systems, such as heat sinks, are applied to an external surface of such an encapsulation material to facilitate the cooling of the associated IC package. Instead, as illustrated in FIG. 1 and described more fully below, encapsulation material 114 may define a plurality of microchannels 120 parallel to a top surface of encapsulation material 114 or IC die 102 that are configured to carry fluid (e.g., water) through encapsulation material 114 under the control of a plurality of flow valves (not depicted in FIG. 1) to facilitate extraction of heat that is generated from the operation the electronic circuitry carried in IC die 102. In the cross-section of FIG. 2, the viewer's point of view coincides with a longitudinal axis of each visible microchannel 120.

FIG. 2 is a top cross-section view of IC package 100 in which encapsulation material 114 defines microchannels 120 directed in two separate directions. More specifically, a first portion of microchannels 120 are aligned in a first direction (e.g., left and right in FIG. 2) parallel to a top of encapsulation material 114, while a second portion of microchannels 120 are aligned in a second direction (e.g., up and down in FIG. 2) parallel to the top of encapsulation material 114 and orthogonal to the first direction. In addition, as shown in FIG. 2, the first and second portions of microchannels 120 intersect, thus forming a two-dimensional microchannel grid or network. In some examples, this grid may be viewed as a plurality of short segments of microchannels 120 arranged vertically and horizontally and attached at their ends. While each microchannel 120 in FIG. 2 is depicted as a straight or linear path, other nonlinear paths (e.g., curved paths) may be implemented in other embodiments. Further, while microchannels 120 form a two-dimensional grid, other configurations or arrangements for microchannels 120 are also possible in other embodiments.

In some embodiments, encapsulation material 114 may define one or more microchannel inlets 204 (e.g., for receiving fluid into encapsulation material 114) and one or more microchannel outlets 206 (e.g., for allowing fluid to exit encapsulation material 114) that couple opposing ends of one or more microchannels 120 to an area or region external to encapsulation material 114. In the particular example of FIG. 1, a microchannel inlet 204 and an opposing microchannel outlet 206 is communicatively coupled with each microchannel 120 of the first portion of microchannels 120. Further, because microchannels 120 are configured as a two-dimensional grid, fluid flowing into microchannel inlets 204 may flow through both the first and second portions of the plurality of microchannels 120 prior to exiting via microchannel outlets 206.

To control the flow of fluid through microchannels 120, a plurality of flow valves 202 may be located at various locations of microchannels 120. In some examples, flow valves 202 may be binary valves that may assume either a fully open state or a fully closed state. In other embodiments, flow valves may assume partially open states (e.g., 25%, 50%, 75%, etc.), possibly in addition to the fully open and fully closed states.

As depicted in FIG. 2, flow valves 202 may be positioned at an intermediate point (e.g., a midpoint) of each microchannel 120 segment, thus capable of allowing, prohibiting, and/or restricting fluid flow through that segment. Consequently, in some embodiments, flow of cooling liquid (e.g., water) may be controlled using flow valves 202 such that a greater flow of the liquid may be directed through warmer portions of IC package 100, and a lesser flow of the liquid may be directed through relatively cooler portions of IC package 100. In some examples, flow valves 202 may be controlled such that a plurality of separate flows may be provided through microchannels 120 between microchannel inlets 204 and microchannel inlets 204

(e.g., by closing a plurality of flow valves 202). Further, flow valves 202 may be controlled such that a plurality of separate flows also extend through microchannel inlets 204 and microchannel outlets 206. For example, flow valves 202 located on first segments of microchannels 120 running directly (e.g., left and right in FIG. 2) between a microchannel inlet 204 and a microchannel outlet 206 may be set to a fully open state, while flow valves 202 located on second segments of microchannels 120 running orthogonally to the first segments of microchannels 120 (e.g., up and down in FIG. 2) may be set to a fully closed state. Consequently, a single separate flow of liquid may be established between each microchannel inlet 204/microchannel outlet 206 pair. Many other individual flows coupling one or more microchannel inlets 204 to one or more microchannel outlets 206 are also possible.

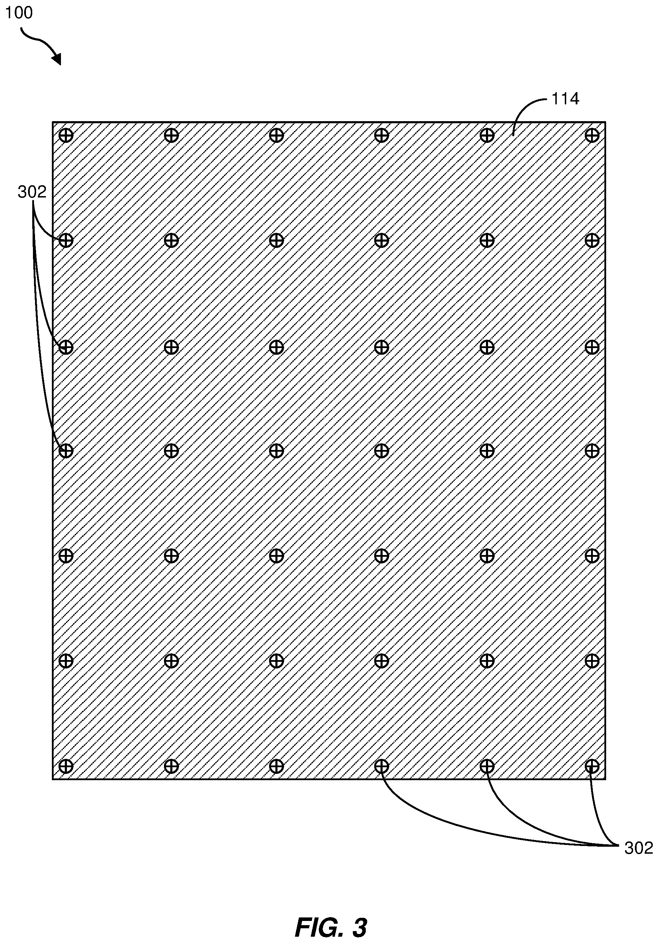

FIG. 3 is a second top cross-section of IC package 100 depicting a plurality of sensors 302 residing in encapsulation material 114. In some embodiments, each sensor 302 may generate a signal indicating (in other words, indicative of) a temperature at the location of sensor 302. Sensors 302 may include heat sensors, heat flux sensors, temperature sensors, and/or other sensors that provide some indication of temperature at the location of the sensor.

In the particular example of FIG. 3, sensors 302 are aligned in a two-dimensional array or grid such that each sensor 302 may be located at an intersection of two microchannels 120. Further, each sensor 302 may be located above or below each such intersection. Other locations for each sensor 302 are also possible, such as, for example, equidistant from each set of four intersections between microchannels 120 (e.g., within each individual "square" of encapsulation material 114 illustrated in FIG. 2.). In yet other embodiments, the sensors may be located in IC die 102 (e.g., incorporated with other electronic circuitry therein) or atop IC die 102.

Encapsulation material 114, in some examples, may also include space (e.g., pathways) for electrical traces or wires (not shown in FIG. 2) to couple a power supply and/or flow control logic with flow valves 202 and/or sensors 302.

In some embodiments, encapsulation material 114 may be molded, machined, or otherwise processed to form microchannels 120, cavities for sensors 302, and/or other cavities therein. In some examples, a layering process (e.g., three-dimensional printing) in which multiple layers of encapsulation material 114 are deposited upon IC die 102 to facilitate generation of the cavities and microchannels 120. As shown in FIG. 2, encapsulation material 114 remaining between microchannels 120 may facilitate retention of the mechanical strength of encapsulation material 114 that may be desired to protect IC die 102 and other portions of IC package 100. However, a lesser or greater amount of encapsulation material 114 remaining between microchannels 120 and/or other cavities or voids may be employed in other examples.

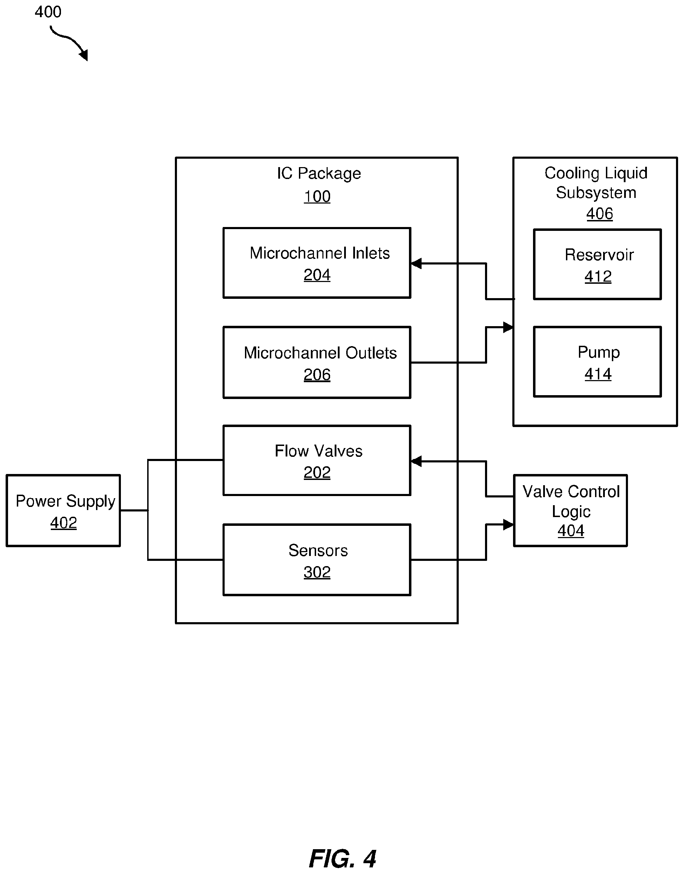

FIG. 4 is a block diagram of an exemplary cooling system 400 including IC package 100 defining microchannel inlets 204 and microchannel outlets 206, each of which couples one or more microchannels 120 (not explicitly shown in FIG. 4) with an exterior of IC package 100, as discussed above. In some embodiments, the plurality of microchannel inlets 204 may be coupled with a single source of cooling fluid (e.g., a single inlet manifold), and the plurality of microchannel outlets 206 may be coupled with a single receiver of cooling fluid (e.g., a single outlet manifold). Also included in IC package 100 may be a plurality of flow valves 202 and a plurality of sensors 302 (e.g., heat sensors), as described earlier. As shown in FIG. 4, cooling system 400 may also include a power supply 402 and valve control logic 404. Also, as depicted in FIG. 4, power supply 402 and valve control logic 404 may reside externally to IC package 100. For example, power supply 402 and valve control logic 404 may reside on a PCB upon which IC package 100 is installed, or in another portion of an electronic system incorporating IC package 100. However, in other examples, power supply 402 and/or valve control logic 404 may be incorporated within IC package 100 (e.g., within or on IC die 102, embedded within encapsulation material 114, or elsewhere). In some embodiments, power supply 402 may supply electrical power to operate flow valves 202, sensors 302, and/or valve control logic 404.

In at least some embodiments, cooling system 400 may also include a cooling liquid subsystem 406 for storing, cooling, and/or providing a cooling liquid for transport through IC package 100 via microchannel inlets 204, microchannels 120, and microchannel outlets 206 (and possibly inlet and output manifolds, as mentioned above) to extract heat from IC package 100. Cooling liquid subsystem 406, in some examples, may include a reservoir 412 that stores the cooling liquid, as well as a pump 414 that drives the cooling liquid through microchannels 120 via microchannel inlets 204 and microchannel outlets 206. As indicated above, cooling liquid may include water; however, other liquids with desirable thermal characteristics may be employed in other embodiments. Further, while embodiments discussed herein involve the use of liquids, other fluids (e.g., gases, or fluids that may be employed in both their gaseous and liquid states) may be utilized in other examples. Consequently, a compressor or other components may be included in cooling liquid subsystem 406 in other embodiments. Also, in some examples, cooling liquid subsystem 406 may be coupled to multiple IC packages 100 to facilitate efficient cooling of each IC package 100.

Valve control logic 404, in some examples, may be hardware control logic or a small algorithmic controller executing instructions stored in a memory device. Generally, valve control logic 404 may receive signals from one or more sensors 302 that each indicate a temperature at a location of the corresponding sensor 302 and, based on those signals, operate flow valves 202 (e.g., to extract heat from portions of IC package that exhibit elevated temperatures, as indicated by the signals of sensors 302).

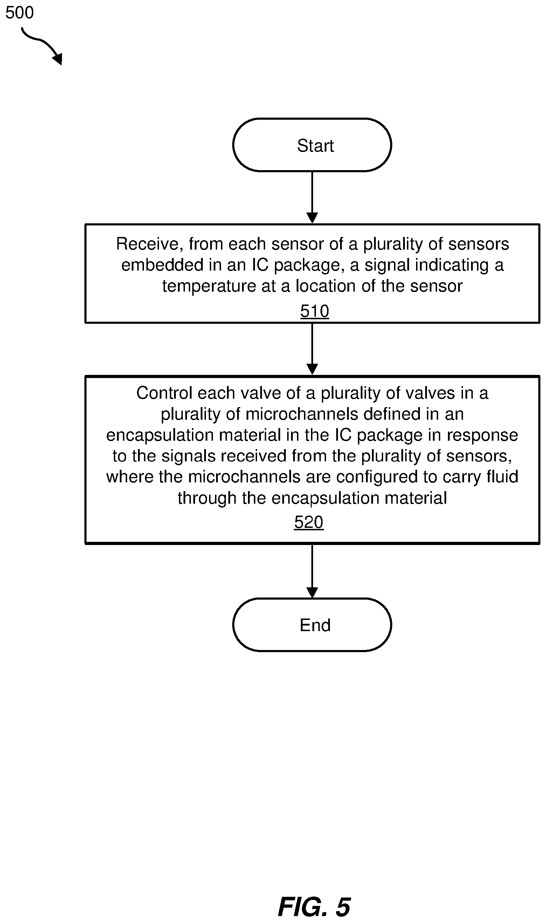

FIG. 5 is a flow diagram of an exemplary method 500 of operating cooling system 400 of FIG. 4. While various embodiments of method 500 are described below in view of IC package 100 as illustrated in FIGS. 1-3, other embodiments of IC package 100, as discussed more generally above, may also benefit from application of method 500.

In method 500, at step 510, a signal may be received (e.g., at valve control logic 404) from each sensor of a plurality of sensors (e.g., sensors 302) embedded in an IC package (e.g., IC package 100) indicating a temperature at a location of the sensor. At step 520, each flow valve of a plurality of flow valves (e.g., flow valves 202) that are located in a plurality of microchannels (e.g., microchannels 120) defined in an encapsulation material (e.g., encapsulation material 114) of the IC package that are configured to carry fluid through the encapsulation material may be controlled in response to the signals from the plurality of sensors. Further, in some examples, the receiving of the signals and the controlling of the valves (e.g., setting one or more flow valves fully open, partially open, fully closed, etc.) may be performed continuously, periodically, or repeatedly over at least some length of time.

More specifically, in some embodiments, in response to one or more sensor 302 signals, valve control logic 404 may identify one or more particular locations or areas of IC package 100 that exhibit an elevated temperature or increased heat. In response, valve control logic 404 may control the plurality of flow valves to increase or maximize fluid flow, and thus enhance heat extraction, through those locations or areas. In some embodiments, such maximization of fluid flow at various portions of the IC package 100 may be facilitated in part by reducing fluid flow in other portions of IC package 100 where heat generation is not currently problematic. Using FIG. 2 as an example, valve control logic 404 may set flow valves 202 such that liquid from multiple microchannel inlets 204 may be focused toward a disproportionately small number of microchannels 120, possibly resulting in a faster-than-average flow through those microchannels. Further, valve control logic 404 may set other flow valves such that liquid from other microchannel inlets 204 are directed to a disproportionately large number of microchannels 120, thus possibly resulting in a reduced flow rate through one or more areas of IC package 100 that are not currently exhibiting heat issues. Other tactics or strategies for cooling particular areas of IC package 100 may be employed by valve control logic 404 in other examples.

As explained above in conjunction with FIGS. 1 through 5, the IC packages described herein, as well as the associated cooling systems and methods discussed above, may facilitate more effective and efficient cooling of an IC package, especially one that exhibits a high TDP that demands an extraordinary level of cooling. More specifically, in some embodiments, heat extraction may be targeted at those portions of the IC package that are currently generating the most heat, and the extraction may be increased or decreased at those specific locations according to the level of heat being detected at the time. Additionally, compared to a heat sink or other passive technology, the cooling system embodiments discussed herein may consume much less volume above the IC package being cooled, possibly resulting in a lower-profile electronic device that employs the IC package.

### Example Embodiments

Example 1: An IC package may include (1) an IC die carrying electronic circuitry, (2) an encapsulation material at least partially covering the IC die, where (a) the encapsulation material defines a plurality of microchannels within the encapsulation material and (b) the plurality of microchannels are configured to carry fluid through the encapsulation material between one or more microchannel inlets and one or more microchannel outlets located at an exterior of the encapsulation material, (3) a plurality of flow valves positioned in the plurality of microchannels, and (4) a plurality of sensors, where each sensor of the plurality of sensors produces a signal indicating a temperature at a location of the sensor.

Example 2: The IC package of Example 1, where at least some of the plurality of microchannels are coupled together to form an interconnected microchannel network.

Example 3: The IC package of either Example 1 or Example 2, where (1) a first subset of the plurality of microchannels may be directed along a first direction parallel to the IC die and (2) a second subset of the plurality of microchannels may be directed along a second direction parallel to the IC die and orthogonal to the first direction.

Example 4: The IC package of Example 3, where (1) each of the first subset of the plurality of microchannels may intersect with the second subset of the plurality of microchannels to form an interconnected microchannel grid including a plurality of microchannel segments and (2) each microchannel segment of the plurality of microchannel segments may couple two intersections of the first subset and the second subset.

Example 5: The IC package of Example 4, where the first subset of the plurality of microchannels may be coupled at opposing ends to separate ones of the one or more microchannel inlets and separate ones of the one or more microchannel outlets.

Example 6: The IC package of Example 4, where each microchannel segment of at least some of the plurality of microchannel segments may incorporate a flow valve of the plurality of flow valves.

Example 7: The IC package of Example 6, where the plurality of sensors may be arranged in a two-dimensional array parallel to a top surface of the IC die.

Example 8: The IC package of Example 7, where each of the plurality of sensors may be aligned vertically relative to each intersection of the first subset and the second subset.

Example 9: The IC package of Example 7, where each of the plurality of sensors may be aligned vertically relative to each microchannel segment of the plurality of microchannel segments.

Example 10: The IC package of either Example 1 or Example 2, where at least one of the plurality of flow valves may be configured to operate either in a fully open state or in a fully closed state.

Example 11: The IC package of either Example 1 or Example 2, where at least one of the plurality of flow valves may be configured to operate in at least one partially open state.

Example 12: A cooling system for an IC package may include (1) a plurality of microchannels defined within an encapsulation material of the IC package, where (a) the encapsulation material at least partially covers an IC die carrying electronic circuitry and (b) the plurality of microchannels are configured to carry fluid through the encapsulation material between one or more microchannel inlets and one or more microchannel outlets located at an exterior of the encapsulation material, (2) a plurality of flow valves positioned in the plurality of microchannels, (3) a pump that pumps fluid through the plurality of microchannels from the one or more microchannel inlets to the one or more microchannel outlets, (4) a plurality of sensors located in the IC package, and (5) valve control logic that (a) receives, from each sensor of the plurality of sensors, a signal indicating a temperature at a location of the sensor and (b) controls, in response to the signals, each flow valve of the plurality of flow valves.

Example 13: The cooling system of Example 12, where the valve control logic may control the plurality of flow valves to increase fluid flow to at least one area of increased temperature, as indicated by the signals from the plurality of sensors.

Example 14: The cooling system of either Example 12 or Example 13, where the valve control logic may control the plurality of flow valves to decrease fluid flow to at least one area of decreased temperature, as indicated by the signals from the plurality of sensors.

Example 15: The cooling system of either Example 12 or Example 13, where the valve control logic may control the plurality of flow valves to create a plurality of separate fluid flows through the plurality of microchannels between the one or more microchannel inlets and the one or more microchannel outlets.

Example 16: The cooling system of either Example 12 or Example 13, where (1) the one or more microchannel inlets may include a plurality of microchannel inlets, (2) the one or more microchannel outlets may include a plurality of microchannel outlets, and (3) the valve control logic may control the plurality of flow valves to create a plurality of separate fluid flows through the plurality of microchannels, the plurality of microchannel inlets, and the plurality of microchannel outlets.

Example 17: A method of cooling an IC package may include (1) receiving, from each sensor of a plurality of sensors included in the IC package that includes an IC die carrying electronic circuitry, a signal indicating a temperature at a location of the sensor and (2) controlling each flow valve of a plurality of flow valves located in a plurality of microchannels defined in an encapsulation material at least partially covering the IC die in response to the signals received from the plurality of sensors, where the plurality of microchannels are configured to carry fluid through the encapsulation material between one or more microchannel inlets and one or more microchannel outlets located at an exterior of the encapsulation material.

**Example** 18: The method of Example 17, where controlling each flow valve of the plurality of flow valves may include (1) identifying a plurality of areas of the IC package exhibiting increased heat based on the signals and (2) controlling each flow valve of the plurality of flow valves to increase fluid flow in the plurality of microchannels through the plurality of areas.

Example 19: The method of Example 18, where controlling each flow valve of the plurality of flow valves may further include controlling each flow valve of the plurality of flow valves to decrease fluid flow in the plurality of microchannels through at least one area of the IC package outside the plurality of areas.

Example 20: The method of Example 18, where controlling each flow valve of the plurality of flow valves may further include controlling each flow valve of the plurality of flow valves to create separate fluid flows between the one or more microchannel inlets and the one or more microchannel outlets for each of the plurality of areas.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various exemplary methods described and/or illustrated herein may also omit one or more of the steps described or illustrated herein or include additional steps in addition to those disclosed.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the present disclosure. The embodiments disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

## Claims

1. An integrated circuit (IC) package comprising:
an IC die (102) carrying electronic circuitry;
an encapsulation material (114) at least partially covering the IC die (102), wherein:
the encapsulation material (114) defines a plurality of microchannels (120) within the encapsulation material (114); and
the plurality of microchannels (120) are configured to carry fluid through the encapsulation material (114) between one or more microchannel inlets (204) and one or more microchannel outlets (206) located at an exterior of the encapsulation material (114);
a plurality of flow valves (202) positioned in the plurality of microchannels (120); and
a plurality of sensors (302), wherein each sensor (302) of the plurality of sensors (302) produces a signal indicating a temperature at a location of the sensor (302);
andwherein at least some of the plurality of microchannels (120) are coupled together to form an interconnected microchannel network.

2. The IC package of claim 1, wherein: a first subset of the plurality of microchannels (120) are directed along a first direction parallel to the IC die (102);
and a second subset of the plurality of microchannels (120) are directed along a second direction parallel to the IC die (102) and orthogonal to the first direction.

3. The IC package of claim 2, wherein: each of the first subset of the plurality of microchannels (120) intersect with the second subset of the plurality of microchannels (120) to form an interconnected microchannel grid comprising a plurality of microchannel segments; and each microchannel segment of the plurality of microchannel segments couples two intersections of the first subset and the second subset.

4. The IC package of claim 3, wherein the first subset of the plurality of microchannels is coupled at opposing ends to separate ones of the one or more microchannel inlets and separate ones of the one or more microchannel outlets.

5. The IC package of claim 3, wherein each microchannel segment of at least some of the plurality of microchannel segments incorporates a flow valve of the plurality of flow valves.

6. The IC package of claim 3, wherein the plurality of sensors (302) are arranged in a two-dimensional array parallel to a top surface of the IC die (102);
and, optionally, wherein each of the plurality of sensors (302) is aligned vertically relative to each intersection of the first subset and the second subset; and/or wherein each of the plurality of sensors (302) is aligned vertically relative to each microchannel segment of the plurality of microchannel segments.

7. The IC package of claim 1, wherein at least one of the plurality of flow valves is configured to operate: either in a fully open state or in a fully closed state; or in at least one partially open state.

8. A cooling system comprising:
at least one IC package (100) of any of claims 1 to 7, a cooling liquid subsystem (406) and a valve control logic (404); wherein
the cooling liquid subsystem (406) comprises a pump (414) that pumps fluid through the plurality of microchannels (120) from the one or more microchannel inlets (204) to the one or more microchannel outlets (206);
and the valve control logic (404) is connected to the at least one IC package (100) and
configured to
receive, from each sensor (302) of the plurality of sensors (302), a signal indicating a temperature at a location of the sensor (302); and
control, in response to the signals, each flow valve of the plurality of flow valves.

9. The cooling system of claim 8, wherein the valve control logic (404) controls the plurality of flow valves to: increase fluid flow to at least one area of increased temperature, as indicated by the signals from the plurality of sensors (302); or decrease fluid flow to at least one area of decreased temperature, as indicated by the signals from the plurality of sensors (302).

10. The cooling system of claim 8, wherein the valve control logic (404) controls the plurality of flow valves to create a plurality of separate fluid flows through the plurality of microchannels between the one or more microchannel inlets and the one or more microchannel outlets.

11. The cooling system of claim 8, wherein:
the one or more microchannel inlets comprise a plurality of microchannel inlets; the one or more microchannel outlets comprise a plurality of microchannel outlets; and
the valve control logic controls the plurality of flow valves to create a plurality of separate fluid flows through the plurality of microchannels, the plurality of microchannel inlets, and the plurality of microchannel outlets.

12. A method of cooling an IC package of any of claims 1 to 7, the method comprising:
receiving (510), from each sensor of a plurality of sensors included in the IC package that includes an IC die carrying electronic circuitry, a signal indicating a temperature at a location of the sensor; and
controlling (520) each flow valve of a plurality of flow valves located in a plurality of microchannels defined in an encapsulation material at least partially covering the IC die in response to the signals received from the plurality of sensors, wherein the plurality of microchannels are configured to carry fluid through the encapsulation material between one or more microchannel inlets and one or more microchannel outlets located at an exterior of the encapsulation material.

13. The method of claim 12, wherein controlling each flow valve of the plurality of flow valves comprises: identifying a plurality of areas of the IC package exhibiting increased heat based on the signals; and
controlling each flow valve of the plurality of flow valves to increase fluid flow in the plurality of microchannels through the plurality of areas.

14. The method of claim 12, wherein controlling each flow valve of the plurality of flow valves further comprises controlling each flow valve of the plurality of flow valves to: decrease fluid flow in the plurality of microchannels through at least one area of the IC package outside the plurality of areas; and/or
create separate fluid flows between the one or more microchannel inlets and the one or more microchannel outlets for each of the plurality of areas.

## Patentansprüche

1. Ein Gehäuse für einen integrierten Schaltkreis (IC), das Folgendes beinhaltet:
ein IC-Die (102), das eine elektronische Schaltung trägt;
ein Verkapselungsmaterial (114), das mindestens teilweise das IC-Die (102) bedeckt,
wobei:
das Verkapselungsmaterial (114) eine Vielzahl von Mikrokanälen (120) innerhalb des Verkapselungsmaterials (114) definiert; und
die Vielzahl von Mikrokanälen (120) konfiguriert ist, um Fluid durch das Verkapselungsmaterial (114) zwischen einem oder mehreren Mikrokanaleinlässen (204) und einem oder mehreren Mikrokanalauslässen (206), die sich an einer Außenseite des Verkapselungsmaterials (114) befinden, zu tragen;
eine Vielzahl von Durchflussventilen (202), die in der Vielzahl von Mikrokanälen (120) positioniert sind; und
eine Vielzahl von Sensoren (302), wobei jeder Sensor (302) der Vielzahl von Sensoren (302) ein Signal erzeugt, das eine Temperatur an einer Stelle des Sensors (302) anzeigt;
und wobei mindestens einige der Vielzahl von Mikrokanälen (120) miteinander gekoppelt sind, um ein miteinander verbundenes Mikrokanalnetzwerk zu bilden.

2. IC-Gehäuse gemäß Anspruch 1, wobei: eine erste Teilmenge der Vielzahl von Mikrokanälen (120) entlang einer ersten Richtung parallel zu dem IC-Die (102) gerichtet ist;
und eine zweite Teilmenge der Vielzahl von Mikrokanälen (120) entlang einer zweiten Richtung parallel zu dem IC-Die (102) und orthogonal zu der ersten Richtung gerichtet ist.

3. IC-Gehäuse gemäß Anspruch 2, wobei: jeder der ersten Teilmenge der Vielzahl von Mikrokanälen (120) die zweite Teilmenge der Vielzahl von Mikrokanälen (120) schneidet, um ein miteinander verbundenes Mikrokanalgitter zu bilden, das eine Vielzahl von Mikrokanalsegmenten beinhaltet; und jedes Mikrokanalsegment der Vielzahl von Mikrokanalsegmenten zwei Schnittpunkte der ersten Teilmenge und der zweiten Teilmenge koppelt.

4. IC-Gehäuse gemäß Anspruch 3, wobei die erste Teilmenge der Vielzahl von Mikrokanälen an gegenüberliegenden Enden mit jeweils separaten der einen oder der mehreren Mikrokanaleinlässe und mit jeweils separaten der einen oder der mehreren Mikrokanalauslässe gekoppelt ist.

5. IC-Gehäuse gemäß Anspruch 3, wobei jedes Mikrokanalsegment von mindestens einigen der Vielzahl von Mikrokanalsegmenten ein Durchflussventil der Vielzahl von Durchflussventilen enthält.

6. IC-Gehäuse gemäß Anspruch 3, wobei die Vielzahl von Sensoren (302) in einer zweidimensionalen Anordnung parallel zu einer oberen Oberfläche des IC-Dies (102) angeordnet ist;
und wobei optional jeder der Vielzahl von Sensoren (302) relativ zu jedem Schnittpunkt der ersten Teilmenge und der zweiten Teilmenge vertikal ausgerichtet ist; und/oder wobei jeder der Vielzahl von Sensoren (302) relativ zu jedem Mikrokanalsegment der Vielzahl von Mikrokanalsegmenten vertikal ausgerichtet ist.

7. IC-Gehäuse gemäß Anspruch 1, wobei mindestens eines der Vielzahl von Durchflussventilen konfiguriert ist, um entweder in einem vollständig offenen Zustand oder in einem vollständig geschlossenen Zustand oder in mindestens einem teilweise offenen Zustand zu arbeiten.

8. Ein Kühlsystem, das Folgendes beinhaltet:
mindestens ein IC-Gehäuse (100) gemäß einem der Ansprüche 1 bis 7, ein Kühlflüssigkeitsteilsystem (406) und eine Ventilsteuerlogik (404); wobei das Kühlflüssigkeitsteilsystem (406) eine Pumpe (414) beinhaltet, die Fluid durch die Vielzahl von Mikrokanälen (120) von dem einen oder den mehreren Mikrokanaleinlässen (204) zu dem einen oder den mehreren Mikrokanalauslässen (206) pumpt;
und die Ventilsteuerlogik (404) mit dem mindestens einen IC-Gehäuse (100) verbunden ist und für Folgendes konfiguriert ist:
Empfangen, von jedem Sensor (302) der Vielzahl von Sensoren (302), eines Signals, das eine Temperatur an einer Stelle des Sensors (302) anzeigt; und
Steuern, als Reaktion auf die Signale, jedes Durchflussventils der Vielzahl von Durchflussventilen.

9. Kühlsystem gemäß Anspruch 8, wobei die Ventilsteuerlogik (404) die Vielzahl von Durchflussventilen für Folgendes steuert: Erhöhen von Fluidfluss zu mindestens einem Bereich erhöhter Temperatur, wie durch die Signale von der Vielzahl von Sensoren (302) angezeigt; oder Verringern von Fluidfluss zu mindestens einem Bereich verringerter Temperatur, wie durch die Signale von der Vielzahl von Sensoren (302) angezeigt.

10. Kühlsystem gemäß Anspruch 8, wobei die Ventilsteuerlogik (404) die Vielzahl von Durchflussventilen steuert, um eine Vielzahl von separaten Fluidflüssen durch die Vielzahl von Mikrokanälen zwischen dem einen oder den mehreren Mikrokanaleinlässen und dem einen oder den mehreren Mikrokanalauslässen zu kreieren.

11. Kühlsystem gemäß Anspruch 8, wobei:
der eine oder die mehreren Mikrokanaleinlässe eine Vielzahl von Mikrokanaleinlässen beinhalten; der eine oder die mehreren Mikrokanalauslässe eine Vielzahl von Mikrokanalauslässen beinhalten; und die Ventilsteuerlogik die Vielzahl von Durchflussventilen steuert, um eine Vielzahl von separaten Fluidflüssen durch die Vielzahl von Mikrokanälen, die Vielzahl von Mikrokanaleinlässen und die Vielzahl von Mikrokanalauslässen zu kreieren.

12. Ein Verfahren zum Kühlen eines IC-Gehäuses gemäß einem der Ansprüche 1 bis 7, wobei das Verfahren Folgendes beinhaltet:
Empfangen (510), von jedem Sensor einer Vielzahl von Sensoren, die in dem IC-Gehäuse umfasst sind, das ein IC-Die umfasst, das eine elektronische Schaltung trägt, eines Signals, das eine Temperatur an einer Stelle des Sensors anzeigt; und
Steuern (520) jedes Durchflussventils einer Vielzahl von Durchflussventilen, die sich in einer Vielzahl von Mikrokanälen befinden, die in einem Verkapselungsmaterial definiert sind, das mindestens teilweise das IC-Die bedeckt, als Reaktion auf die von der Vielzahl von Sensoren empfangenen Signale, wobei die Vielzahl von Mikrokanälen konfiguriert ist, um Fluid durch das Verkapselungsmaterial zwischen einem oder mehreren Mikrokanaleinlässen und einem oder mehreren Mikrokanalauslässen, die sich an einer Außenseite des Verkapselungsmaterials befinden, zu tragen.

13. Verfahren gemäß Anspruch 12, wobei das Steuern jedes Durchflussventils der Vielzahl von Durchflussventilen Folgendes beinhaltet: Identifizieren einer Vielzahl von Bereichen des IC-Gehäuses, die erhöhte Wärme aufweisen, basierend auf den Signalen; und Steuern jedes Durchflussventils der Vielzahl von Durchflussventilen, um Fluidfluss in der Vielzahl von Mikrokanälen durch die Vielzahl von Bereichen zu erhöhen.

14. Verfahren gemäß Anspruch 12, wobei das Steuern jedes Durchflussventils der Vielzahl von Durchflussventilen ferner das Steuern jedes Durchflussventils der Vielzahl von Durchflussventilen für Folgendes beinhaltet: Verringern von Fluidfluss in der Vielzahl von Mikrokanälen durch mindestens einen Bereich des IC-Gehäuses außerhalb der Vielzahl von Bereichen; und/oder
Kreieren von separaten Fluidflüssen zwischen dem einen oder den mehreren Mikrokanaleinlässen und dem einen oder den mehreren Mikrokanalauslässen für jeden der Vielzahl von Bereichen.

## Revendications

1. Un boîtier de circuit intégré (CI) comprenant :
une puce de CI (102) portant une circuiterie électronique ;
une matière d'encapsulation (114) recouvrant au moins partiellement la puce de CI (102), dans laquelle :
la matière d'encapsulation (114) définit une pluralité de microcanaux (120) à l'intérieur de la matière d'encapsulation (114) ; et
la pluralité de microcanaux (120) sont configurés pour transporter un fluide à travers la matière d'encapsulation (114) entre une ou plusieurs entrées de microcanaux (204) et une ou plusieurs sorties de microcanaux (206) situées à l'extérieur de la matière d'encapsulation (114) ;
une pluralité de vannes d'écoulement (202) positionnées dans la pluralité de microcanaux (120) ; et
une pluralité de capteurs (302), dans laquelle chaque capteur (302) de la pluralité de capteurs (302) produit un signal indiquant une température à un emplacement du capteur (302) ;
et dans laquelle au moins certains de la pluralité de microcanaux (120) sont reliés ensemble pour former un réseau de microcanaux interconnectés.

2. Le boîtier de CI de la revendication 1, dans lequel : un premier sous-ensemble de la pluralité de microcanaux (120) sont dirigés le long d'une première direction parallèle à la puce de CI (102) ;
et un deuxième sous-ensemble de la pluralité de microcanaux (120) sont dirigés le long d'une deuxième direction parallèle à la puce de CI (102) et orthogonale à la première direction.

3. Le boîtier de CI de la revendication 2, dans lequel : chacun du premier sous-ensemble de la pluralité de microcanaux (120) intersecte le deuxième sous-ensemble de la pluralité de microcanaux (120) pour former une grille de microcanaux interconnectés comprenant une pluralité de segments de microcanaux ; et chaque segment de microcanal de la pluralité de segments de microcanaux couple deux intersections du premier sous-ensemble et du deuxième sous-ensemble.

4. Le boîtier de CI de la revendication 3, dans lequel le premier sous-ensemble de la pluralité de microcanaux est relié, à des extrémités opposées, à des entrées de microcanaux distinctes parmi les une ou plusieurs entrées de microcanaux et à des sorties de microcanaux distinctes parmi les une ou plusieurs sorties de microcanaux.

5. Le boîtier de CI de la revendication 3, dans lequel chaque segment de microcanal d'au moins certains de la pluralité de segments de microcanaux incorpore une vanne d'écoulement de la pluralité de vannes d'écoulement.

6. Le boîtier de CI de la revendication 3, dans lequel la pluralité de capteurs (302) sont agencés dans un réseau bidimensionnel parallèle à une surface supérieure de la puce de CI (102) ;
et, facultativement, dans lequel chaque capteur de la pluralité de capteurs (302) est aligné verticalement par rapport à chaque intersection du premier sous-ensemble et du deuxième sous-ensemble ; et/ou dans lequel chaque capteur de la pluralité de capteurs (302) est aligné verticalement par rapport à chaque segment de microcanal de la pluralité de segments de microcanaux.

7. Le boîtier de CI de la revendication 1, dans lequel au moins une de la pluralité de vannes d'écoulement est configurée pour fonctionner : soit dans un état complètement ouvert, soit dans un état complètement fermé ; soit dans au moins un état partiellement ouvert.

8. Un système de refroidissement comprenant :
au moins un boîtier de CI (100) de n'importe lesquelles des revendications 1 à 7, un sous-système de liquide de refroidissement (406) et une logique de commande de vanne (404) ; dans lequel
le sous-système de liquide de refroidissement (406) comprend une pompe (414) qui pompe un fluide à travers la pluralité de microcanaux (120) depuis les une ou plusieurs entrées de microcanaux (204) vers les une ou plusieurs sorties de microcanaux (206) ;
et la logique de commande de vanne (404) connectée à l'au moins un boîtier de CI (100) et configurée pour
recevoir, depuis chaque capteur (302) de la pluralité de capteurs (302), un signal indiquant une température à un emplacement du capteur (302) ; et
commander, en réponse aux signaux, chaque vanne d'écoulement de la pluralité de vannes d'écoulement.

9. Le système de refroidissement de la revendication 8, dans lequel la logique de commande de vanne (404) commande la pluralité de vannes d'écoulement pour :
augmenter un écoulement de fluide vers au moins une zone de température augmentée, comme indiqué par les signaux provenant de la pluralité de capteurs (302) ; ou diminuer un écoulement de fluide vers au moins une zone de température diminuée, comme indiqué par les signaux provenant de la pluralité de capteurs (302).

10. Le système de refroidissement de la revendication 8, dans lequel la logique de commande de vanne (404) commande la pluralité de vannes d'écoulement pour créer une pluralité d'écoulements de fluide distincts à travers la pluralité de microcanaux entre les une ou plusieurs entrées de microcanaux et les une ou plusieurs sorties de microcanaux.

11. Le système de refroidissement de la revendication 8, dans lequel :
les une ou plusieurs entrées de microcanaux comprennent une pluralité d'entrées de microcanaux ; les une ou plusieurs sorties de microcanaux comprennent une pluralité de sorties de microcanaux ; et la logique de commande de vanne commande la pluralité de vannes d'écoulement pour créer une pluralité d'écoulements de fluide distincts à travers la pluralité de microcanaux, la pluralité d'entrées de microcanaux, et la pluralité de sorties de microcanaux.

12. Un procédé de refroidissement d'un boîtier de CI de n'importe lesquelles des revendications 1 à 7, le procédé comprenant :
la réception (510), depuis chaque capteur d'une pluralité de capteurs inclus dans le boîtier de CI qui inclut une puce de CI portant une circuiterie électronique, d'un signal indiquant une température à un emplacement du capteur ; et
la commande (520) de chaque vanne d'écoulement d'une pluralité de vannes d'écoulement situées dans une pluralité de microcanaux définis dans une matière d'encapsulation recouvrant au moins partiellement la puce de CI en réponse aux signaux reçus de la pluralité de capteurs, dans lequel la pluralité de microcanaux sont configurés pour transporter un fluide à travers la matière d'encapsulation entre une ou plusieurs entrées de microcanaux et une ou plusieurs sorties de microcanaux situées au niveau d'un extérieur de la matière d'encapsulation.

13. Le procédé de la revendication 12, dans lequel la commande de chaque vanne d'écoulement de la pluralité de vannes d'écoulement comprend : l'identification d'une pluralité de zones du boîtier de CI présentant une chaleur augmentée sur la base des signaux ; et
la commande de chaque vanne d'écoulement de la pluralité de vannes d'écoulement pour augmenter un écoulement de fluide dans la pluralité de microcanaux à travers la pluralité de zones.

14. Le procédé de la revendication 12, dans lequel la commande de chaque vanne d'écoulement de la pluralité de vannes d'écoulement comprend en outre la commande de chaque vanne d'écoulement de la pluralité de vannes d'écoulement pour : diminuer un écoulement de fluide dans la pluralité de microcanaux à travers au moins une zone du boîtier de CI à l'extérieur de la pluralité de zones ; et/ou
créer des écoulements de fluide distincts entre les une ou plusieurs entrées de microcanaux et les une ou plusieurs sorties de microcanaux pour chacune de la pluralité de zones.
